# FASCICULE DE BREVET EUROPEEN

(11) **EP 3 069 340 B1**
(45) Date de publication et mention de la délivrance du brevet: **20.09.2017**
(21) Numéro de dépôt: 14821711.0
(22) Date de dépôt: 14.11.2014
(51) Int. Cl.: G10L 19/20, G10L 19/04, G10L 19/02

(54) **TRANSITION D'UN CODAGE/DÉCODAGE PAR TRANSFORMÉE VERS UN CODAGE/DÉCODAGE PRÉDICTIF**
ÜBERGANG VON EINER TRANSFORMATIONSCODIERUNG/-DECODIERUNG ZU EINER PRÄDIKTIVEN CODIERUNG/DECODIERUNG
TRANSITION FROM A TRANSFORM CODING/DECODING TO A PREDICTIVE CODING/DECODING

(30) Priorité: 15.11.2013 FR 1361243
(43) Date de publication de la demande: 21.09.2016
(73) Titulaire: Orange, 75015 Paris (FR)
(72) Inventeur: FAURE, Julien, 22300 Ploubezre (FR); RAGOT, Stéphane, F-22300 Lannion (FR)
(74) Mandataire: Froger, Marie-Hélène
(86) Numéro de dépôt international: PCT/FR2014/052923
(87) Numéro de publication internationale: WO 2015/071613

(56) Documents cités:
- WO-A1-2013/016262
- US-A1- 2006 271 359
- LECOMTE J., GOURNAY P., GEIGER R., BESSETTE B., NEUENDORF R.: "Efficient Cross-Fade Windows for Transitions between LPC-Based and Non-LPC Based Audio Coding", AES CONVENTION 126; MAY 2009, AES, 60 EAST 42ND STREET, ROOM 2520 NEW YORK 10165-2520, USA, 1 mai 2009 (2009-05-01), XP040508994,

## Description

La présente invention concerne le domaine du codage des signaux numériques.

Le codage selon l'invention est adapté notamment pour la transmission et/ou le stockage de signaux audio numériques tels que des signaux audiofréquences (parole, musique ou autres).

L'invention s'applique avantageusement au codage unifié des signaux de parole, de musique et de contenu mixte, par le biais de techniques multi-modes alternant au moins deux modes de codage et dont le retard algorithmique est adapté aux applications conversationnelles (typiquement ≤ 40 ms).

Pour coder efficacement les sons de parole, les techniques de type CELP (« Code Excited Linear Prediction ») ou sa variante ACELP (pour " Algebraic Code Excited Linear Prediction") sont préconisées, des alternatives au codage CELP telles que les codeurs BV16, BV32, iLBC ou SILK ont également été proposées plus récemment. Pour coder efficacement les sons musicaux, on préconise plutôt les techniques de codage par transformée.

Les codeurs par prédiction linéaire, et plus particulièrement ceux de type CELP, sont des codeurs prédictifs. Ils ont pour but de modéliser la production de la parole à partir d'au moins une partie des éléments suivants: une prédiction linéaire à court-terme pour modéliser le conduit vocal, une prédiction à long-terme pour modéliser la vibration des cordes vocales en période voisée, et une excitation dérivée d'un dictionnaire de quantification vectorielle en général qualifié de dictionnaire fixe (bruit blanc, excitation algébrique) pour représenter l' "innovation" qui n'a pas pu être modélisée par prédiction.

Les codeurs par transformée les plus utilisés (codeur MPEG AAC ou ITU-T G.722.1 Annexe C par exemple) utilisent des transformées à échantillonnage critique de type MDCT (Pour "Modified Discrete Transform") afin de compacter le signal dans le domaine transformé. On appelle « transformée à échantillonnage critique », une transformée pour laquelle le nombre de coefficients dans le domaine transformé est égal au nombre d'échantillons temporels analysés.

Une solution pour coder efficacement un signal contenant ces deux types de contenu, consiste à sélectionner au cours du temps (trame par trame) la meilleure technique. Cette solution a notamment été préconisée par l'organisme de standardisation 3GPP (« 3rd Generation Partnership Project ») par une technique nommée AMR WB+ (ou Enhanced AMR-WB) et plus récemment par le codec MPEG-H USAC (Pour "Unified Speech Audio Coding" en anglais). Les applications visées par AMR-WB+ et USAC ne sont pas conversationnelles, mais correspondent à des services de diffusion et stockage, sans contraintes fortes sur le retard algorithmique.

La norme USAC est publiée dans le document ISO/IEC 23003-3:2012, Information technology -- MPEG audio technologies -- Part 3: Unified speech and audio coding.

A titre illustratif, la version initiale du codec USAC, appelée RM0 (Reference Model 0), est décrite dans l'article de M. Neuendorf et al., A Novel Scheme for Low Bitrate Unified Speech and Audio Coding - MPEG RM0, 7-10 May 2009, 126th AES Convention. Ce codec alterne entre au moins deux modes de codage:
- Pour les signaux de type parole: modes **LPD** (Pour "Linear Predictive Domain") utilisant une technique ACELP
- Pour les signaux de type musique: mode **FD** (Pour "Frequency Domain") utilisant une technique MDCT (Pour "Modified Discrete Transform")
On rappelle ci-dessous les principes des codages ACELP et MDCT.

D'un côté, le codage CELP - dont sa variante ACELP - est un codage prédictif fondé sur le modèle source-filtre. Le filtre correspond en général à un filtre tout-pôle de fonction de transfert 1/*A*(*z*) obtenu par prédiction linéaire (LPC pour Linear Predictive Coding). En pratique la synthèse utilise la version quantifiée, 1/*Â*(*z*), du filtre 1/*A*(*z*). La source - c'est-à-dire l'excitation du filtre linéaire prédictif 1/*Â*(*z*) - est en général la combinaison d'une excitation obtenue par prédiction long-terme modélisant la vibration des cordes vocales, et d'une excitation stochastique (ou innovation) décrite sous la forme de codes algébriques (ACELP), de dictionnaires de bruit, etc. La recherche de l'excitation "optimale" est réalisée par minimisation d'un critère d'erreur quadratique dans le domaine du signal pondéré par un filtre de fonction de transfert *W*(*z*) en générale dérivée du filtre de prédiction linéaire *A*(*z*), de la forme W(*z*)= *A*(*z*/*γ1*)/*A*(*z*/*γ2*). On notera que de nombreuses variantes du modèle CELP ont été proposées et on retiendra ici l'exemple du codage CELP de la norme UIT-T G.718 dans lequel deux filtres LPC sont quantifiés par trame et l'excitation LPC est codée en fonction d'une classification, avec des modes adaptés aux sons voisés, non voisés, transitoires, etc... De plus, des alternatives au codage CELP ont également été proposées, dont les codeurs BV16, BV32, iLBC ou SILK qui restent à base de prédiction linéaire. En général le codage prédictif, dont le codage CELP, fonctionne à des fréquences d'échantillonnage limitées (≤16 kHz) pour des raisons historiques et autres (limites de la prédiction linéaire en bande large, complexité algorithmique pour des fréquences élevées, etc...) ; ainsi, pour fonctionner avec des fréquences de typiquement 16 à 48 kHz, on utilise également des opérations de ré-échantillonnage (par filtre FIR, bancs de filtre ou filtre IIR) et éventuellement un codage séparé de la bande haute qui peut être une extension de bande paramétrique - ces opérations de ré-échantillonnage et de codage de bande haute ne sont pas revues ici.

D'un autre côté, le codage par transformation MDCT se divise entre trois étapes au codeur:
1. Pondération du signal par une fenêtre appelé ici "fenêtre MDCT" sur une longueur correspondante à 2 blocs
2. Repliement temporel (ou "time-domain aliasing" en anglais) pour former un bloc réduit (de longueur divisée par 2)
3. Transformation DCT-IV ("Discrete Cosine Transform") du bloc réduit

On notera que des variantes de calcul de type transformation TDAC qui peuvent utiliser par exemple une transformée de Fourier (FFT) au lieu d'une transformée DCT.

La fenêtre MDCT est en général divisée en 4 portions adjacentes de longueurs égales appelées "quarts".

Le signal est multiplié par la fenêtre d'analyse puis les repliements sont effectués : le premier quart (fenêtré) est replié (c'est-à-dire inversé dans le temps et mis en recouvrement) sur le deuxième et le quatrième quart est replié sur le troisième.

Plus précisément, le repliement d'un quart sur un autre est effectué de la façon suivante : Le premier échantillon du premier quart est additionné (ou soustrait) au dernier échantillon du deuxième quart, le deuxième échantillon du premier quart est additionné (ou soustrait) à l'avant-dernier échantillon du deuxième quart, et ainsi de suite jusqu'au dernier échantillon du premier quart qui est additionné (ou soustrait) au premier échantillon du deuxième quart.

On obtient donc à partir de 4 quarts, 2 quarts repliés où chaque échantillon est le résultat d'une combinaison linéaire de 2 échantillons du signal à coder. Cette combinaison linéaire est appelée repliement temporel. On notera que le repliement temporel (aussi appelé « temporal aliasing » en anglais) correspond à mélanger deux segments temporels et le niveau relatif de deux segments temporels dans chaque « quart replié » est fonction des fenêtres d'analyse/synthèse.

Ces 2 quarts repliés sont ensuite codés conjointement après transformation DCT. Pour la trame suivante on se décale d'une moitié de fenêtre (soit 50% de recouvrement), les troisième et quatrième quarts de la trame précédente deviennent le premier et deuxième quart de la trame courante. Après repliement on envoie une deuxième combinaison linéaire des mêmes paires d'échantillons comme dans la trame précédente, mais avec des poids différents.

Au décodeur, après transformation DCT inverse on obtient donc la version décodée de ces signaux repliés. Deux trames consécutives contiennent le résultat de 2 repliements différents des mêmes 2 quarts, c'est à dire pour chaque paire d'échantillons on a le résultat de 2 combinaisons linéaires avec des poids différents mais connus : un système d'équation est donc résolu pour obtenir la version décodée du signal d'entrée, le repliement temporel peut être ainsi supprimé en utilisant 2 trames décodées consécutives.

La résolution des systèmes d'équations mentionnées est en général faite par dépliement, multiplication par une fenêtre de synthèse judicieusement choisie puis addition-recouvrement des parties communes. Cette addition-recouvrement assure en même temps la transition douce (sans discontinuité due aux erreurs de quantification) entre 2 trames décodées consécutives, en effet cette opération se comporte comme un fondu enchainé. Quand la fenêtre pour le premier quart ou de quatrième quart est à zéro pour chaque échantillon, on parle d'une transformation MDCT sans repliement temporel dans cette partie de la fenêtre. Dans ce cas la transition douce n'est pas assurée par la transformation MDCT, elle doit être faite par d'autres moyens comme par exemple un fondu enchainé extérieur.

Le codage par transformée (dont le codage de type MDCT) peut en théorie facilement s'adapter à différentes fréquences d'échantillonnage d'entrée et de sortie, comme l'illustre la mise en oeuvre combinée dans l'annexe C de G.722.1 incluant le codage G.722.1 ; on peut cependant aussi utiliser le codage par transformée avec des opérations de pré/post-traitement avec ré-échantillonnage (par filtre FIR, bancs de filtre ou filtre IIR), avec éventuellement un codage séparé de la bande haute qui peut être une extension de bande paramétrique - ces opérations de ré-échantillonnage et de codage de bande haute ne sont pas revues ici, mais le codeur 3GPP e-AAC+ donne un exemple de réalisation d'une telle combinaison (ré-échantillonnage, codage par transformée en bande basse et extension de bande).

Il est à noter que la bande acoustique codée par les différents modes (LPD temporel à base de prédiction linéaire, FD fréquentiel à base de transformée) peut varier selon le mode sélectionné et le débit. Par ailleurs, la décision de mode peut être réalisée en boucle ouverte (ou "open-loop" en anglais) pour chaque trame, c'est-à-dire que la décision est prise a priori en fonction des données et des observations disponibles, ou en boucle fermée comme dans le codage AMR-WB+.

Dans les codecs utilisant au moins deux modes de codages, les transitions entre modes LPD et FD sont importantes pour assurer une qualité suffisante sans défaut de commutation, sachant que les modes FD et LPD sont de nature différentes - l'un repose sur un codage par transformée dans le domaine fréquentiel du signal, tandis que l'autre utilise un codage linéaire prédictif (temporel) avec des mémoires de filtres qui sont mises à jour à chaque trame. Un exemple de gestion des commutations inter-modes correspondant au codec USAC RM0 est détaillée dans l'article de J. Lecomte et al., "Efficient cross-fade windows for transitions between LPC-based and non-LPC based audio coding", 7-10 May 2009, 126th AES Convention. Comme expliqué dans cet article, la difficulté principale réside dans les transitions entre modes LPD vers FD et vice versa.

Pour traiter le problème de transition entre un coeur de type FD à un coeur de type LPD, la demande de brevet publiée sous le numéro WO2013/016262 (illustrée à la figure 1) propose de mettre à jour les mémoires des filtres du codec de type LPD (130) codant la trame m+1 en utilisant la synthèse du codeur et du décodeur de type FD (140) codant la trame m. La mise à jour des mémoires étant nécessaire uniquement pendant le codage des trames de type FD. Cette technique permet ainsi lors de la sélection en 110 du mode de codage et du basculement (en 150) du codage de type FD vers LPD, de le faire sans défaut de transition (artefacts) puisqu'au moment de coder la trame avec la technique LPD, les mémoires (ou états) du codeur CELP (LPD) ont déjà été mis à jour par le générateur 160 à partir du signal reconstruit *Ŝₐ*(*n*) de la trame m. Dans le cas où les deux coeurs (FD et LDP) ne fonctionnent pas à la même fréquence d'échantillonnage, la technique décrite dans la demande WO2013/016262 propose une étape de ré-échantillonnage des mémoires du codeur de type FD.

Cette technique a pour inconvénient d'une part qu'elle nécessite d'avoir accès au signal décodé au codeur et donc de forcer une synthèse locale dans le codeur. D'autre part elle nécessite de faire des opérations de mise à jour des mémoires des filtres (pouvant comprendre une étape de ré-échantillonnage) au moment du codage et du décodage de type FD, ainsi qu'un ensemble d'opérations revenant à réaliser une analyse/codage de type CELP dans la trame précédente de type FD. Ces opérations peuvent être complexes et viennent se superposer aux opérations de codage/décodage classiques dans la trame de transition de type LPD, ce qui occasionne un pic de complexité en codage « multi-modes».

Il existe donc un besoin d'obtenir une transition efficace entre un codage ou décodage par transformée et un codage ou décodage prédictif qui ne nécessitent pas une augmentation en complexité des codeurs ou décodeurs prévus pour des applications conversationnelles de codage audio présentant des alternances de parole et de musique.

La présente invention vient améliorer la situation.
Elle propose à cet effet, un procédé de décodage d'un signal audio numérique, comportant les étapes de :
- décodage selon un décodage par transformée inverse d'une trame précédente d'échantillons du signal numérique reçue et codée selon un codage par transformée ;
- décodage selon un décodage prédictif d'une trame courante d'échantillons du signal numérique reçue et codée selon un codage prédictif. Le procédé est tel que le décodage prédictif de la trame courante est un décodage prédictif de transition qui n'utilise pas de dictionnaire adaptatif issu de la trame précédente et qu'il comporte en outre:
- une étape de réinitialisation d'au moins un état du décodage prédictif à une valeur par défaut prédéterminée;
- une étape d'addition-recouvrement qui combine un segment de signal synthétisé par décodage prédictif de la trame courante et un segment de signal synthétisé par décodage par transformée inverse, correspondant à un segment mémorisé du décodage de la trame précédente.

Ainsi, la réinitialisation des états s'effectue sans qu'il n'y ait besoin du signal décodé de la trame précédente, elle s'effectue de façon très simple par des valeurs constantes nulles ou prédéterminées. La complexité du décodeur est ainsi diminuée par rapport aux techniques de mise à jour des mémoires d'états nécessitant de l'analyse ou autres calculs. Les artefacts de transition sont alors évités par la mise en oeuvre de l'étape d'addition-recouvrement qui permet de faire le lien avec la trame précédente.

Avec le décodage prédictif de transition, il n'est pas nécessaire de réinitialiser les mémoires du dictionnaire adaptatif pour cette trame courante puisqu'il n'est pas utilisé. Ceci simplifie d'autant plus la mise en oeuvre de la transition.

Dans un mode de réalisation particulier, le décodage par transformée inverse a un retard de traitement inférieur à celui du décodage prédictif et le premier segment de trame courante décodée par décodage prédictif est remplacé par un segment issu du décodage de la trame précédente correspondant au décalage de retard et mis en mémoire lors du décodage de la trame précédente.

Ceci permet d'utiliser avantageusement ce décalage de retard pour améliorer la qualité de la transition.
Dans un mode de réalisation particulier, le segment de signal synthétisé par décodage par transformée inverse est corrigé avant l'étape d'addition-recouvrement par l'application d'une fenêtre inverse compensant le fenêtrage préalablement appliqué au segment.

Ainsi, la trame courante décodée a une énergie qui est proche de celle du signal original.

Dans une variante de réalisation, le segment de signal synthétisé par décodage par transformée inverse est préalablement ré-échantillonné à la fréquence d'échantillonnage correspondante au segment de signal décodé de la trame courante.

Ceci permet d'effectuer une transition sans défaut dans le cas où la fréquence d'échantillonnage du décodage par transformée est différente de celle du décodage prédictif.

Dans un mode de réalisation de l'invention, un état du décodage prédictif est dans la liste des états suivants:
- la mémoire d'état d'un filtre de ré-échantillonnage à la fréquence interne du décodage prédictif;
- les mémoires d'état de filtres de pré-emphase/dé-emphase;
- les coefficients du filtre de prédiction linéaire;
- la mémoire d'état du filtre de synthèse (dans le domaine préaccentué)
- la mémoire du dictionnaire adaptatif (excitation passée)
- la mémoire d'état d'un post-filtre basse fréquence (BPF)
- la mémoire de quantification du gain de dictionnaire fixe.

Ces états sont utilisés pour mettre en oeuvre le décodage prédictif. La plupart de ces états sont réinitialisés à une valeur nulle ou une valeur constante prédéterminée, ce qui simplifie d'autant plus la mise en oeuvre de cette étape. Cette liste n'est cependant pas exhaustive et d'autres états peuvent bien évidemment être pris en compte dans cette étape de réinitialisation.

Dans un mode de réalisation particulier de l'invention, le calcul des coefficients du filtre de prédiction linéaire de la trame courante s'effectue par le décodage des coefficients d'un filtre unique et en attribuant des coefficients identiques au filtre de prédiction linéaire de fin, de milieu et de début de trame.

En effet, comme les coefficients du filtre de prédiction linéaire ont été réinitialisés, les coefficients de début de trame ne sont pas connus. Les valeurs décodées sont alors utilisées pour obtenir les coefficients du filtre de prédiction linéaire de la trame complète. Ceci s'effectue donc de façon simple sans pour autant apporter de dégradation importante au signal audio décodé.

Dans une variante de réalisation, le calcul des coefficients du filtre de prédiction linéaire de la trame courante comporte les étapes suivantes :
- détermination des valeurs décodées des coefficients du filtre de milieu de trame en utilisant les valeurs décodées des coefficients du filtre de fin de trame et une valeur prédéterminée de réinitialisation des coefficients du filtre de début de trame;
- remplacement des valeurs décodées des coefficients du filtre de début de trame par les valeurs décodées des coefficients du filtre de milieu de trame;
- détermination des coefficients du filtre de prédiction linéaire de la trame courante en utilisant les valeurs ainsi décodées des coefficients du filtre de fin, de milieu et de début de trame.

Ainsi, les coefficients correspondant au filtre de milieu de trame sont décodés avec une erreur plus faible.

Dans une autre variante de réalisation, les coefficients du filtre de prédiction linéaire de début de trame sont réinitialisées à une valeur prédéterminée correspondant à une valeur moyenne des coefficients de filtre de prédiction à long terme et les coefficients de prédiction linéaire de la trame courante sont déterminés en utilisant les valeurs ainsi prédéterminées et les valeurs décodées des coefficients du filtre de fin de trame.

Ainsi, les coefficients de début de trame sont considérés comme connus avec la valeur prédéterminée. Cela permet de retrouver les coefficients de la trame complète de façon plus exacte et de stabiliser plus rapidement le décodage prédictif.

Dans un mode possible de réalisation, une valeur par défaut prédéterminée dépend du type de trame à décoder.

Ainsi le décodage est bien adapté au signal à décoder.

L'invention se rapporte également à un procédé de codage d'un signal audio numérique, comportant les étapes de :
- codage d'une trame précédente d'échantillons du signal numérique selon un codage par transformée ;
- réception d'une trame courante d'échantillons du signal numérique à coder selon un codage prédictif. Le procédé est tel que le codage prédictif de la trame courante est un codage prédictif de transition qui n'utilise pas de dictionnaire adaptatif issu de la trame précédente et qu'il comporte en outre:
   - une étape de réinitialisation d'au moins un état du codage prédictif à une valeur par défaut prédéterminée.

Ainsi, la réinitialisation des états s'effectue sans qu'il n'y ait besoin de reconstruction du signal de la trame précédente et donc de décodage local. Elle s'effectue de façon très simple par des valeurs constantes nulles ou prédéterminées. La complexité du codage est ainsi diminuée par rapport aux techniques de mise à jour des mémoires d'états nécessitant de l'analyse ou autres calculs.

Avec le codage prédictif de transition, il n'est pas nécessaire de réinitialiser les mémoires du dictionnaire adaptatif pour cette trame courante puisqu'il n'est pas utilisé. Ceci simplifie d'autant plus la mise en oeuvre de la transition.
Dans un mode de réalisation particulier, les coefficients du filtre de prédiction linéaire font partie d'au moins un état du codage prédictif et le calcul des coefficients du filtre de prédiction linéaire de la trame courante s'effectue par la détermination des valeurs codées des coefficients d'un seul filtre de prédiction, soit de milieu soit de fin de trame et d'attribution de valeurs codées identiques pour les coefficients du filtre de prédiction de début de trame et de fin ou milieu de trame.

En effet, comme les coefficients du filtre de prédiction linéaire ont été réinitialisés, les coefficients de début de trame ne sont pas connus. Les valeurs codées sont alors utilisées pour obtenir les coefficients du filtre de prédiction linéaire de la trame complète. Ceci s'effectue donc de façon simple sans pour autant apporter de dégradation importante au signal sonore codé.

Ainsi, avantageusement, au moins un état du codage prédictif est codé de manière directe.

En effet, les bits normalement réservés au codage du jeu de coefficients du filtre de milieu de trame ou de début de trame sont utilisés par exemple pour coder de manière directe au moins un état du codage prédictif, par exemple la mémoire du filtre de dé-emphase.

Dans une variante de réalisation, les coefficients du filtre de prédiction linéaire font partie d'au moins un état du codage prédictif et le calcul des coefficients du filtre de prédiction linéaire de la trame courante comporte les étapes suivantes :
- détermination des valeurs codées des coefficients du filtre de milieu de trame en utilisant les valeurs codées des coefficients du filtre de fin de trame et les valeurs prédéterminées de réinitialisation des coefficients du filtre de début de trame;
- remplacement des valeurs codées des coefficients du filtre de début de trame par les valeurs codées des coefficients du filtre de milieu de trame;
- détermination des coefficients du filtre de prédiction linéaire de la trame courante en utilisant les valeurs ainsi codées des coefficients du filtre de fin, de milieu et de début de trame.

Ainsi, les coefficients correspondant au filtre de milieu de trame sont codés avec un pourcentage d'erreur plus faible.

Dans une variante de réalisation, les coefficients du filtre de prédiction linéaire font partie d'au moins un état du codage prédictif, les coefficients du filtre de prédiction linéaire de début de trame sont réinitialisées à une valeur prédéterminée correspondant à une valeur moyenne des coefficients de filtre de prédiction à long terme et les coefficients de prédiction linéaire de la trame courante sont déterminés en utilisant les valeurs ainsi prédéterminées et les valeurs codées des coefficients du filtre de fin de trame.

Ainsi, les coefficients de début de trame sont considérés comme connus avec la valeur prédéterminée.. Cela permet d'obtenir une bonne estimation des coefficients de prédiction de la trame précédente, sans analyse supplémentaire, pour calculer les coefficients de prédiction de la trame complète.

Dans un mode possible de réalisation, une valeur par défaut prédéterminée dépend du type de trame à coder.

L'invention se rapporte également à un décodeur de signal audio numérique, comprenant :
- une entité de décodage par transformée inverse apte à décoder une trame précédente d'échantillons du signal numérique reçue et codée selon un codage par transformée ;
- une entité de décodage prédictif apte à décoder une trame courante d'échantillons du signal numérique reçue et codée selon un codage prédictif. Le décodeur est tel que le décodage prédictif de la trame courante est un décodage prédictif de transition qui n'utilise pas de dictionnaire adaptatif issu de la trame précédente et qu'il comporte en outre:
- un module de réinitialisation apte à réinitialiser au moins un état du décodage prédictif par une valeur par défaut prédéterminée;
- un module de traitement apte à effectuer une addition-recouvrement qui combine un segment de signal synthétisé par décodage prédictif de la trame courante et un segment de signal synthétisé par décodage par transformée inverse, correspondant à un segment mémorisé du décodage de la trame précédente.

De même l'invention se rapporte à un codeur de signal audio numérique, comprenant :
- une entité de codage par transformée apte à coder une trame précédente d'échantillons du signal numérique ;
- une entité de codage prédictif apte à coder une trame courante d'échantillons du signal numérique. Le codeur est tel que le codage prédictif de la trame courante est un codage prédictif de transition qui n'utilise pas de dictionnaire adaptatif issu de la trame précédente et qu'il comporte en outre:
- un module de réinitialisation apte à réinitialiser au moins un état du codage prédictif par une valeur par défaut prédéterminée.

Le décodeur et le codeur apportent les mêmes avantages que les procédés de décodage et de codage qu'ils mettent en oeuvre respectivement.

Enfin l'invention se rapporte à un programme informatique comportant des instructions de code pour la mise en oeuvre des étapes du procédé de décodage tel que décrit précédemment et/ou de codage tel que décrit précédemment, lorsque ces instructions sont exécutées par un processeur.

L'invention se rapporte aussi à un moyen de stockage, lisible par un processeur, intégré ou non au décodeur ou au codeur, éventuellement amovible, mémorisant un programme informatique mettant en oeuvre un procédé de décodage et/ou un procédé de codage tels que décrits précédemment.

D'autres caractéristiques et avantages de l'invention apparaîtront à l'examen de la description détaillée ci-après, et des figures annexées parmi lesquelles :

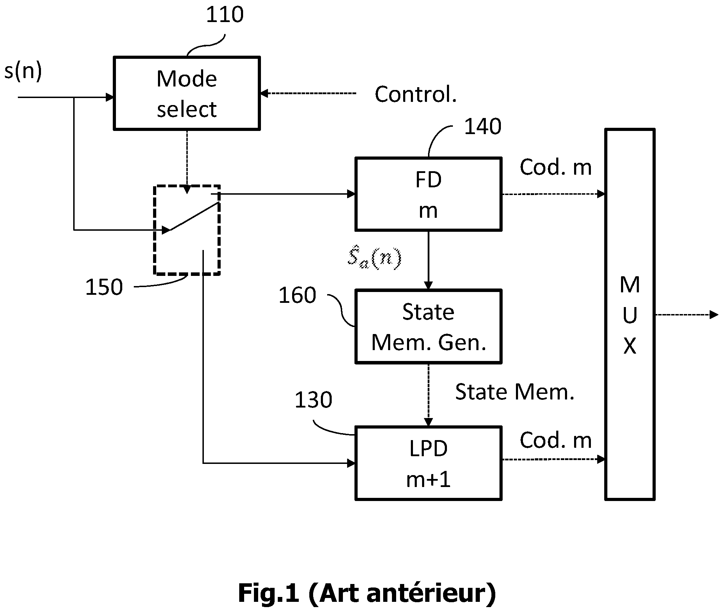

- la figure 1 illustre une méthode de transition, entre un codage par transformée et un codage prédictif, de l'état de l'art et décrit précédemment;
- la figure 2 illustre la transition au codeur entre une trame codée selon un codage par transformée et une trame codée selon un codage prédictif, selon une mise en oeuvre de l'invention;
- la figure 3 illustre un mode de réalisation du procédé de codage et du codeur selon l'invention;
- la figure 4 illustre sous forme d'organigramme les étapes mises en oeuvre dans un mode de réalisation particulier, pour déterminer les coefficients du filtre de prédiction linaire lors du codage prédictif de la trame courante, la trame précédente ayant été codée selon un codage par transformée;
- la figure 5 illustre la transition au décodeur entre une trame décodée selon un décodage par transformée inverse et une trame décodée selon un décodage prédictif, selon une mise en oeuvre de l'invention;
- la figure 6 illustre un mode de réalisation du procédé de décodage et du décodeur selon l'invention;
- la figure 7 illustre sous forme d'organigramme les étapes mises en oeuvre dans un mode de réalisation de l'invention, pour déterminer les coefficients du filtre de prédiction linaire lors du décodage prédictif de la trame courante, la trame précédente ayant été décodée selon un décodage par transformée inverse;
- la figure 8 illustre l'étape d'addition-recouvrement mise en oeuvre au décodage selon un mode de réalisation de l'invention;
- la figure 9 illustre un mode particulier de mise en oeuvre de la transition entre décodage par transformée et décodage prédictif lorsqu'ils ont des retards différents;et
- la figure 10 illustre un mode de réalisation matérielle du codeur ou du décodeur selon l'invention.

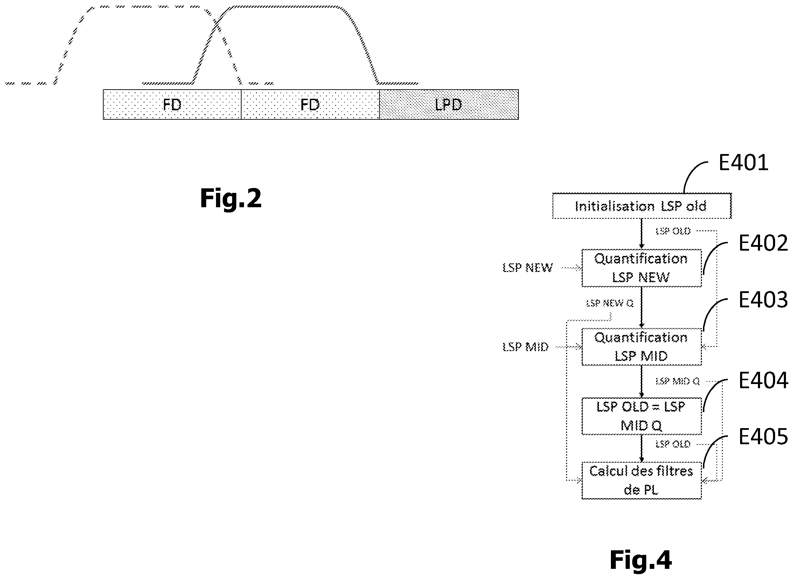

La **figure 2** illustre de façon schématique, le principe de codage lors d'une transition entre un codage par transformée et un codage prédictif selon l'invention.
On considère ici une succession de trame audio à coder soit avec un codeur par transformée (FD) par exemple de type MDCT soit avec un codeur prédictif (LPD) par exemple de type ACELP ; on notera que des modes supplémentaires de codage sont possibles sans affecter l'invention. Le codeur par transformé (FD) utilise dans cet exemple des fenêtres à faibles retard de type "Tukey" (l'invention est indépendante du type de fenêtre utilisé) et dont la longueur totale est égale à deux trames (valeurs à zéro comprises) comme représenté sur la figure.

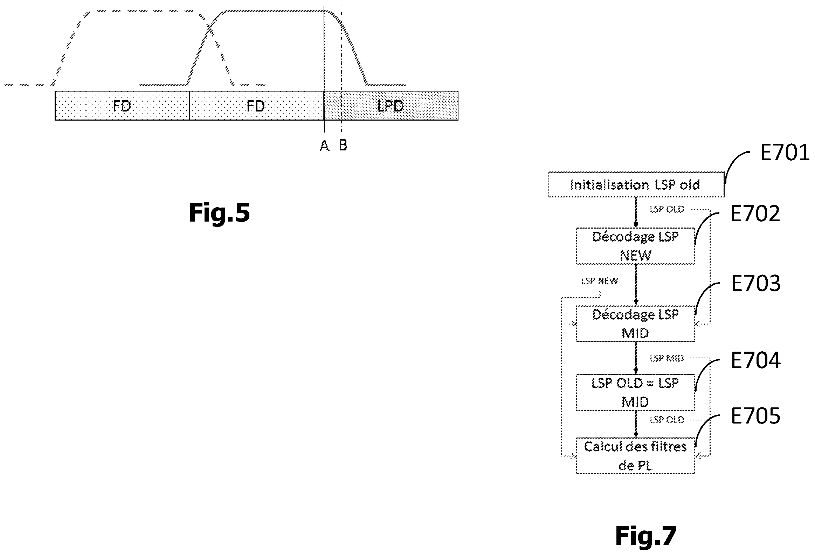

Lors du codage, les fenêtres du codeur FD sont synchronisées de manière à ce que la dernière partie non nulle de la fenêtre (à droite) corresponde avec la fin d'une nouvelle trame du signal d'entrée. A noter que le découpage en trames illustré à la figure 2 inclut le "lookahead" (ou signal futur) et la trame réellement codée est donc typiquement décalée dans le temps (retardée) comme expliqué plus loin en rapport à la figure 5. Lorsqu'il n'y a pas de transition, le codeur effectue la procédure de repliement et de transformation par DCT telle que décrite dans l'état de l'art (MDCT). Lors de l'arrivée de la trame devant être codée par un codeur de type LPD, la fenêtre n'est pas appliquée, les états ou mémoires correspondants aux filtres du codeur LPD sont réinitialisées à des valeurs prédéterminées.

On considère ici que le codeur LPD est dérivé du codeur UIT-T G.718 dont le codage CELP fonctionne à une fréquence interne de 12.8 kHz. Le codeur LPD selon l'invention peut fonctionner à deux fréquences internes 12.8 kHz ou 16 kHz selon le débit.

Par état du codage prédictif (LPD), on sous-entend au moins les états suivants:
- La mémoire d'état du filtre de ré-échantillonnage de la fréquence d'entrée fs à la fréquence interne du codage CELP (12.8 ou 16 kHz). On considère ici que le ré-échantillonnage peut s'effectuer en fonction des fréquences d'entrée et interne par filtre FIR, banc de filtres ou filtre IIR, sachant qu'une réalisation de type FIR simplifie l'utilisation de la mémoire d'état qui correspond au signal d'entrée passé.
- Les mémoires d'état des filtres de pré-emphase (1-αz⁻¹ avec typiquement α=0.68) et de dé-emphase (1/(1-αz⁻¹))
- Les coefficients du filtre de prédiction linéaire à la fin de la trame précédente ou leur version équivalente dans les domaines tels que les domaines LSF ("Line Spectral Frequencies") ou ISF ("Imittance Spectral Frequencies").
- La mémoire d'état du filtre de synthèse LPC typiquement d'ordre 16 (dans le domaine préaccentué)
- La mémoire du dictionnaire adaptatif (excitation CELP passée)
- La mémoire d'état du post-filtre basse fréquence (BPF) comme défini dans la norme UIT-G.718 (voir clause 7.14.1.1 de la norme UIT-T G.718)
- La mémoire de quantification du gain de dictionnaire fixe (lorsque cette quantification s'effectue avec mémoire)

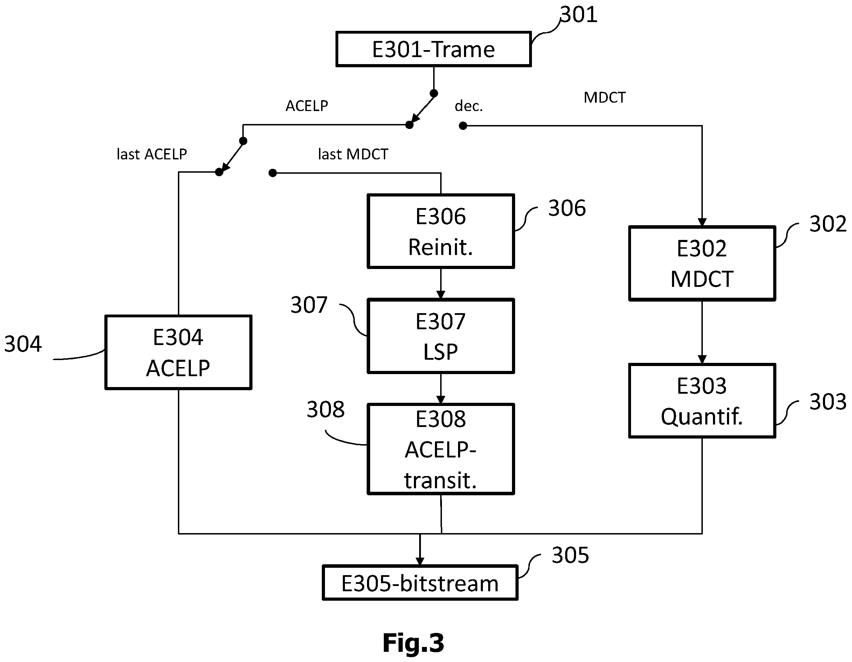

La **figure 3** illustre un mode de réalisation d'un codeur et d'un procédé de codage selon l'invention.

Le mode particulier de réalisation se situe dans le cadre de transition entre un codec par transformée FD utilisant une MDCT et un codec prédictif de type ACELP.

Après une première étape classique de mise en trame (E301) par un module 301, un module de décision (dec.) détermine si la trame à traiter doit être codée en codage prédictif ACELP ou en codage par transformée FD.

Dans le cas du codage par transformée, une étape complète de transformée MDCT est effectué (E302) par l'entité de codage par transformée 302. Cette étape comprend entre autre un fenêtrage avec une fenêtre bas délai alignée comme illustrée sur la figure 2, une étape de repliement et une étape de transformation dans le domaine DCT. La trame FD est ensuite quantifiée dans une étape (E303) par un module de quantification 303 puis les données ainsi encodées sont écrite dans le flux binaire (bitstream) en E305, par le module 305 de construction de flux binaire.

Le cas de la transition d'un codage prédictif vers un codage par transformée n'est pas traité dans cet exemple puisqu'il ne fait pas l'objet de la présente invention.

Si l'étape de décision (dec.) choisie le codage prédictif ACELP, alors:
- Soit la trame précédente (last ACELP) avait aussi été encodée par l'entité de codage ACELP 304, le codage ACELP (E304) se poursuit alors tout en mettant à jour les mémoires ou états du codage prédictif. On ne traite pas ici du problème de commutation de fréquences d'échantillonnage internes du codage CELP (de 12.8 à 16 kHz et vice-versa). Les informations codées et quantifiées sont écrites dans le flux binaire dans une étape E305.
- Soit la trame précédente (last MDCT) avait été encodée par l'entité de codage par transformée 302, en E302, dans ce cas, les mémoires ou états du codage prédictif ACELP sont réinitialisées dans une étape (E306) à des valeurs par défaut prédéterminées à l'avance (pas nécessairement nulles). Cette étape de réinitialisation est mise en oeuvre par le module de réinitialisation 306, pour au moins un état du codage prédictif.
Une étape de codage prédictif pour la trame courante est alors mise en oeuvre en E308 par une entité de codage prédictif 308.
Les informations codées et quantifiées sont écrites dans le flux binaire à l'étape E305.

Ce codage prédictif E308 peut, dans un mode de réalisation particulier, être un codage de transition tel que défini sous le nom de 'TC mode' dans la norme UIT-T G.718, dans lequel le codage de l'excitation est direct et n'utilise pas de dictionnaire adaptatif issu de la trame précédente. On réalise alors un codage de l'excitation indépendant de la trame précédente. Cette réalisation permet aux codeurs prédictifs de type LPD de se stabiliser beaucoup plus rapidement (par rapport à un codage CELP classique qui utiliserait un dictionnaire adaptatif qui serait mis à zéro. Ceci simplifie d'autant plus la mise en oeuvre de la transition selon l'invention.

Dans une variante de l'invention, le codage de l'excitation pourra ne pas être dans un mode de transition mais utilisera un codage CELP de façon similaire à G.718 et pouvant utiliser un dictionnaire adaptatif (sans forcer ni limiter la classification) ou un codage CELP classique avec dictionnaires adaptatif et fixe. Cette variante est cependant moins avantageuse car le dictionnaire adaptatif n'ayant pas été recalculé et ayant été mis à zéro, le codage sera sous-optimal.

Dans une autre variante, le codage CELP dans la trame de transition par mode TC pourra être remplacé par tout autre type de codage indépendant de la trame précédente, par exemple en utilisant le modèle de codage de type iLBC.

Dans un mode de réalisation particulier, une étape E307 de calcul des coefficients du filtre de prédiction linéaire pour la trame courante est effectuée par le module de calcul 307.
Plusieurs modes de calcul des coefficients du filtre de prédiction linéaire sont possibles pour la trame courante. On considère ici que le codage prédictif (bloc 304) effectue deux analyses de prédiction linéaire par trame comme dans la norme G.718, avec un codage des coefficients LPC sous forme d'ISF (ou LSF de façon équivalente) obtenus à la fin de trame (NEW) et un codage à débit très réduit des coefficients LPC obtenus au milieu de la trame (MID), avec une interpolation par sous-trame entre les coefficients LPC de la fin de trame précédente (OLD), et ceux de la trame courante (MID et NEW).

Dans un premier mode de réalisation, les coefficients de prédiction dans la trame précédente (OLD) de type FD ne sont pas connus car aucun coefficient LPC n'est codé dans le codeur FD. On choisit alors de coder un seul jeu de coefficient du filtre de prédiction linéaire qui correspond soit au milieu de la trame (MID) ou soit à la fin de la trame (NEW). Ce choix peut être fait par exemple selon une classification du signal à coder. Pour un signal stable, le filtre de milieu de trame pourra être choisi. Un choix arbitraire peut aussi être fait; dans le cas où le choix se porte sur les coefficients LPC au milieu de la trame, dans une variante, l'interpolation des coefficients LPC (dans le domaine ISP ("Imittance Spectral Pairs") ou LSP ("Line Spectral Pairs")) pourra être modifiée dans la seconde trame LPD qui suit la trame LPD de transition.
A partir de ces valeurs codées obtenues, on attribue des valeurs codées identiques pour les coefficients de filtre de prédiction de début de trame (OLD) et de fin ou milieu de trame selon le choix qui a été effectué. En effet, les coefficients LPC de la trame précédente (OLD) n'étant pas connus, il n'est pas possible de coder les coefficients LPC de milieu de trame (MID) comme dans G.718. On notera que dans cette variante la réinitialisation des coefficients LPC (OLD) n'est pas forcément nécessaire, car ces coefficients ne sont pas utilisés. Dans ce cas, les coefficients utilisés dans chaque sous-trame sont fixés de façon identique à la valeur codée dans la trame.

Avantageusement, les bits qui pourraient être réservés au codage du jeu de coefficients LPC de milieu de trame (MID) ou de début de trame sont utilisés par exemple pour coder de manière directe au moins un état du codage prédictif, par exemple la mémoire du filtre de dé-emphase.

Dans un deuxième mode possible de réalisation, les étapes illustrées sur la figure 4 sont mises en oeuvre. Une première étape E401 est l'initialisation des coefficients du filtre de prédiction et des représentations équivalentes ISF ou LSF selon la mise en oeuvre de l'étape E306 de la figure 3, c'est-à-dire à des valeurs prédéterminées, par exemple selon la valeur moyenne à long-terme sur une base d'apprentissage a priori des coefficients LSP. L'étape E402 code les coefficients du filtre de fin de trame (LSP NEW) et les valeurs codées obtenues (LEP NEW Q) ainsi que les valeurs prédéterminées de réinitialisation des coefficients du filtre de début de trame (LSP OLD) sont utilisées en E403 pour coder les coefficients du filtre de prédiction de milieu de trame (LSP MID). Une étape de remplacement E404 des valeurs de coefficients de début de trame (LSP OLD) par les valeurs codées des coefficients de milieu de trame (LSP MID Q), est effectuée. L'étape E405 permet de déterminer les coefficients du filtre de prédiction linéaire de la trame courante à partir de ces valeurs ainsi codées (LSP OLD, LSP MID Q, LSP NEW Q).

Dans un troisième mode possible de réalisation, les coefficients du filtre de prédiction linéaire de la trame précédente (LSP OLD) sont initialisés à une valeur qui est déjà disponible « gratuitement » dans une variante de codeur FD utilisant une enveloppe spectrale de type LPC. Dans ce cas, un codage « normal » tel qu'utilisé dans G.718 pourra être utilisé, les coefficients de prédiction linéaires par sous-trame étant calculés comme une interpolation entre les valeurs des filtres de prédiction OLD, MID et NEW, cette opération permet ainsi au codeur LPD d'obtenir sans analyse supplémentaire une bonne estimation des coefficients LPC dans la trame précédente.

Dans d'autres variantes de l'invention, le codage LPD pourra par défaut ne coder qu'un jeu de coefficients LPC (NEW), les variantes de réalisation précédentes sont simplement adaptées pour prendre en compte qu'aucun jeu de coefficients n'est disponible au milieu de trame (MID).

Dans une variante de réalisation de l'invention, l'initialisation des états du codage prédictif peut être effectuée avec des valeurs par défaut prédéterminées à l'avance qui peuvent par exemple correspondre à différents type de trame à encoder (par exemple les valeurs d'initialisation peuvent êtres différentes si la trame comporte un signal de type voisé ou non voisé).

La **figure 5** illustre de façon schématique, le principe de décodage lors d'une transition entre un décodage par transformée et un décodage prédictif selon l'invention.

On considère ici une succession de trame audio à décoder soit avec un décodeur par transformée (FD) par exemple de type MDCT soit avec un décodeur prédictif (LPD) par exemple de type ACELP. Le décodeur par transformé (FD) utilise dans cet exemple des fenêtres de synthèse à faibles retard de type "Tukey" (l'invention est indépendante du type de fenêtre utilisé) et dont la longueur totale est égale à deux trames (valeurs à zéro comprises) comme représenté sur la figure.

Au sens de l'invention, après le décodage d'une trame codée avec un codeur FD, une transformation DCT inverse est appliquée à la trame décodée. Cette dernière est dépliée puis la fenêtre de synthèse est appliquée sur le signal déplié. Les fenêtres de synthèse du codeur FD sont synchronisées de manière à ce que la partie non nulle de la fenêtre (à gauche) corresponde avec une nouvelle trame. Ainsi, la trame peut être décodée jusqu'au point A puisque le signal n'a pas de repliement temporel ("d'aliasing") avant ce point.

Au moment de l'arrivée de la trame LPD, comme au codeur, les états ou mémoires du décodage prédictif sont réinitialisées à des valeurs prédéterminées.

Par état du décodage prédictif (LPD), on sous-entend au moins les états suivants:
- La mémoire d'état du filtre de ré-échantillonnage de la fréquence interne du décodage CELP (12.8 ou 16 kHz) à la fréquence de sortie fs. On considère ici que le ré-échantillonnage peut s'effectuer en fonction des fréquences d'entrée et interne par filtre FIR, banc de filtres ou filtre IIR, sachant qu'une réalisation de type FIR simplifie l'utilisation de la mémoire d'état qui correspond au signal d'entrée passé.
- Les mémoires d'état du filtre de dé-emphase (1/(1-αz⁻¹))
- Les coefficients du filtre de prédiction linéaire à la fin de la trame précédente ou leur version équivalente dans les domaines tels que les domaines LSF (Line Spectral Frequencies) ou ISF (Imittance Spectral Frequencies).
- La mémoire d'état du filtre de synthèse LPC typiquement d'ordre 16 (dans le domaine préaccentué)
- La mémoire du dictionnaire adaptatif (excitation passée)
- La mémoire d'état du post-filtre basse fréquence (BPF) comme défini dans la norme UIT-G.718 (voir clause 7.14.1.1 de la norme UIT-T G.718)
- La mémoire de quantification du gain de dictionnaire fixe (lorsque cette quantification s'effectue avec mémoire)

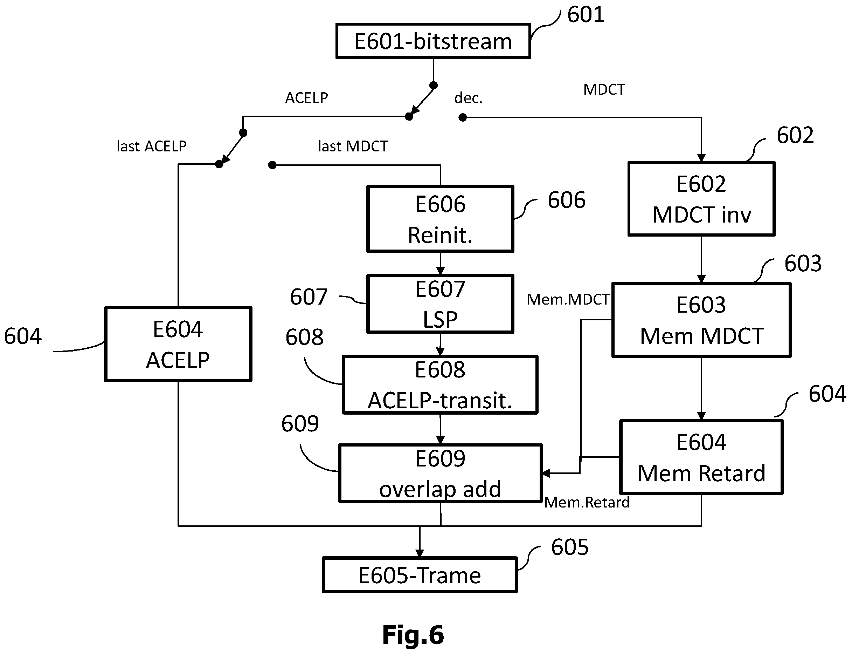

La **figure 6** illustre un mode de réalisation d'un décodeur et d'un procédé de décodage selon l'invention.

Le mode particulier de réalisation se situe dans le cadre de transition entre un codec par transformée FD utilisant une MDCT et un codec prédictif de type ACELP.

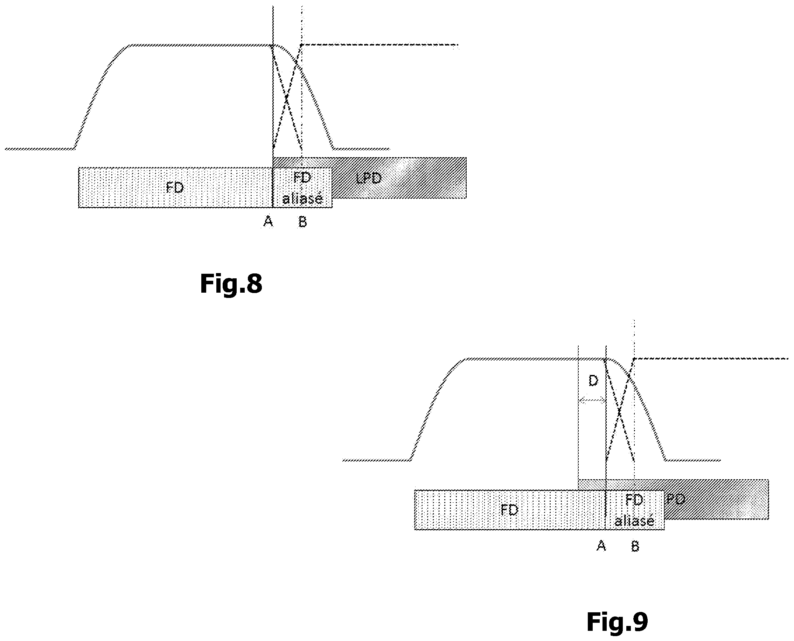

Après une première étape classique de lecture dans le train binaire (E601) par un module 601, un module de décision (dec.) détermine si la trame à traiter doit être décodée en décodage prédictif ACELP ou en décodage par transformée FD. Dans le cas d'un décodage par transformée MDCT, une étape de décodage E602 par l'entité de décodage par transformée 602, permet d'obtenir la trame dans le domaine transformé. L'étape peut également contenir une étape de ré-échantillonnage à la fréquence d'échantillonnage du décodeur ACELP. Cette étape est suivie d'une transformation MDCT inverse E603 comprenant, une transformation DCT inverse, un dépliement temporel, et l'application d'une fenêtre de synthèse et d'une étape d'addition-recouvrement avec la trame précédente comme décrit ultérieurement en référence à la figure 8.

La partie pour laquelle le repliement temporel a été annulé est mise en trame dans une étape E605 par le module de mise en trame 605. La partie qui comprend un repliement temporel est gardée en mémoire (Mem. MDCT) pour faire une étape d'addition-recouvrement en E609 par le module de traitement 609 avec l'éventuelle prochaine trame décodée par le coeur FD. Dans une variante, la partie mémorisée du décodage MDCT qui est utilisée pour l'étape d'addition-recouvrement, ne comporte pas de repliement temporel, par exemple dans le cas où il existe un décalage temporel suffisamment important entre le décodage MDCT et le décodage CELP.

Cette étape est illustrée en **figure 8****.** On voit sur cette figure qu'il existe une discontinuité temporelle entre le décodage issu du FD et celui du LPD. L'étape E609 utilise la mémoire du codeur par transformée (Mem. MDCT), telle que décrite ci-dessus, c'est-à-dire le signal décodé après le point A mais qui comporte du repliement (dans le cas illustré).

Préférentiellement, le signal est utilisé jusqu'au point B qui est le point de repliement de la transformée. Dans un mode particulier de réalisation, on compense au préalable ce signal par l'inverse de la fenêtre préalablement appliquée sur le segment AB. Ainsi, avant l'étape d'addition-recouvrement le segment AB est corrigé par l'application d'une fenêtre inverse compensant le fenêtrage préalablement appliqué au segment. Le segment n'est donc plus « fenêtré » et son énergie est proche de celle du signal original.

Les deux segments AB, celui issu du décodage par transformée et celui issu du décodage prédictif sont ensuite pondérés et sommés afin d'obtenir le signal AB final. Les fonctions de pondération ont préférentiellement une somme égale à 1 (du type linéaire ou sinusoïdal quadratique par exemple). Ainsi, l'étape d'addition-recouvrement combine un segment de signal synthétisé par décodage prédictif de la trame courante et un segment de signal synthétisé par décodage par transformée inverse, correspondant à un segment mémorisé du décodage de la trame précédente.

Dans un autre mode de réalisation particulier, dans le cas où le ré-échantillonnage n'a pas encore été effectué (en E602 par exemple), le segment de signal synthétisé par décodage par transformée inverse de type FD est préalablement ré-échantillonné à la fréquence d'échantillonnage correspondante au segment de signal décodé de la trame courante de type LPD. Ce ré-échantillonnage de la mémoire MDCT pourra se faire avec ou sans retard avec des techniques classiques par filtre de type FIR, banc de filtres , filtre IIR voire en utilisant des "splines".

Dans le cas contraire, si les modes de codage FD et LPD fonctionnent à des fréquences d'échantillonnage internes différentes, on pourra dans une alternative ré-échantillonner la synthèse du codage CELP (éventuellement post-traitée avec en particulier l'ajout d'un bande haute estimée ou codée) et appliquer l'invention. Ce ré-échantillonnage de la synthèse du codeur LPD pourra se faire avec ou sans retard avec des techniques classiques par filtre de type FIR, banc de filtres, filtre IIR voire en utilisant des "splines".

Ceci permet d'effectuer une transition sans défaut dans le cas où la fréquence d'échantillonnage du décodage par transformée est différente de celle du décodage prédictif.

Dans un mode de réalisation particulier, il est possible d'appliquer une étape intermédiaire de retard (E604) afin d'aligner temporellement les deux décodeurs si le décodeur FD a moins de délai que le décodeur CELP (LPD). Une partie de signal dont la taille correspond au délai entre les deux décodeurs est alors stocké en mémoire (Mem.retard).

La **figure 9** illustre ce cas de figure. Le mode de réalisation ici, propose de tirer avantageusement parti de cette différence de délai D pour remplacer le premier segment D issu du décodage prédictif LPD par celui issu du décodage par transformée FD puis de procéder à l'étape d'addition-recouvrement (E609) telle que décrite précédemment, sur le segment AB. Ainsi, lorsque le décodage par transformée inverse a un retard de traitement inférieur à celui du décodage prédictif, le premier segment de trame courante décodée par décodage prédictif est remplacé par un segment issu du décodage de la trame précédente correspondant au décalage de retard et mis en mémoire lors du décodage de la trame précédente.

A la figure 6, si la décision (dec.) indique qu'il faut faire un décodage prédictif ACELP, alors :
- Soit la dernière trame décodée, trame précédente (last ACELP), était aussi décodée selon un décodage prédictif ACELP par l'entité de décodage ACELP 603, le décodage prédictif se poursuit alors dans une étape (E603), la trame audio est ainsi produite en E605.
- Soit la trame précédente (last MDCT) a été décodée par l'entité de décodage par transformée 602, en E602, dans ce cas, une étape de réinitialisation (E606) des états du décodage prédictif ACELP est appliquée. Cette étape de réinitialisation est mise en oeuvre par le module de réinitialisation 606, pour au moins un état du décodage prédictif. Les valeurs de réinitialisation sont des valeurs par défaut prédéterminées à l'avance (pas nécessairement nulles).

L'initialisation des états du décodage LPD peut être faite avec des valeurs par défaut prédéterminées à l'avance qui peuvent par exemple correspondre à différents type de trame à décoder en fonction de ce qui a été fait lors de l'encodage.

Une étape de décodage prédictif pour la trame courante est alors mise en oeuvre en E608 par une entité de décodage prédictif 608, avant l'étape d'addition-recouvrement (E609) décrite précédemment. L'étape peut également contenir une étape de ré-échantillonnage à la fréquence d'échantillonnage du décodeur MDCT.

Ce codage prédictif E608 peut, dans un mode de réalisation particulier, être un décodage prédictif de transition, si cette solution a été choisie à l'encodeur, dans lequel le décodage de l'excitation est direct et n'utilise pas de dictionnaire adaptatif. Dans ce cas, la mémoire du dictionnaire adaptatif n'a pas besoin d'être réinitialisée.

On réalise alors un décodage non prédictif de l'excitation. Cette réalisation permet aux décodeurs prédictifs de type LPD de se stabiliser beaucoup plus rapidement puisque dans ce cas, il n'utilise pas la mémoire du dictionnaire adaptatif qui avait été préalablement réinitialisée. Ceci simplifie d'autant plus la mise en oeuvre de la transition selon l'invention. Au moment du décodage de la trame courante, le décodage prédictif de l'excitation long terme est remplacé par un décodage non prédictif de l'excitation.

Dans un mode particulier de réalisation, une étape E607 de calcul des coefficients du filtre de prédiction linéaire pour la trame courante est effectuée par le module de calcul 607.

Plusieurs modes de calcul des coefficients du filtre de prédiction linéaire sont possibles pour la trame courante.

Dans un premier mode de réalisation, les coefficients de prédiction dans la trame précédente (OLD) de type FD ne sont pas connus car aucun coefficient LPC n'est codé dans le codeur FD et les valeurs ont été réinitialisées à zéro. On choisit alors de décoder des coefficients d'un filtre de prédiction linéaire unique, soit celui correspondant au filtre de prédiction de fin de trame (NEW), soit celui correspondant au filtre de prédiction de milieu de la trame (MID). On attribue ensuite des coefficients identiques au filtre de prédiction linéaire de fin, de milieu et de début de trame.

Dans un deuxième mode possible de réalisation, les étapes illustrées sur la figure 7 sont mises en oeuvre. Une première étape E701 est l'initialisation des coefficients du filtre de prédiction (LSP OLD) selon la mise en oeuvre de l'étape E606 de la figure 6. L'étape E702 décode les coefficients du filtre de fin de trame (LSP NEW) et les valeurs décodées obtenues (LSP NEW) ainsi que les valeurs prédéterminées de réinitialisation des coefficients du filtre de début de trame (LSP OLD) sont utilisées conjointement en E703 pour décoder les coefficients du filtre de prédiction de milieu de trame (LSP MID). Une étape de remplacement E704 des valeurs de coefficients de début de trame (LSP OLD) par les valeurs décodées des coefficients de milieu de trame (LSP MID), est effectuée. L'étape E705 permet de déterminer les coefficients du filtre de prédiction linéaire de la trame courante à partir de ces valeurs ainsi décodées (LSP OLD, LSP MID, LSP NEW).

Dans un troisième mode possible de réalisation, les coefficients du filtre de prédiction linéaire de la trame précédente (LSP OLD) sont initialisés à une valeur prédéterminée, par exemple selon la valeur moyenne à long-terme des coefficients LSP. Dans ce cas, un décodage « normal » tel qu'utilisé dans G.718 pourra être utilisé, les coefficients de prédiction linéaire par sous-trame étant calculés comme une interpolation entre les valeurs des filtres de prédiction OLD, MID et NEW. Cette opération permet ainsi au codeur LPD de se stabiliser plus rapidement.

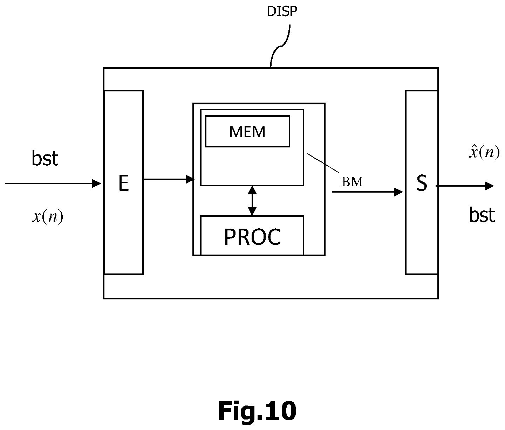

En référence à la **figure 10****,** on décrit un dispositif matériel adapté pour réaliser un codeur ou un décodeur selon un mode de réalisation de la présente invention.

Ce codeur ou décodeur peut être intégré à un terminal de communication, une passerelle de communication ou tout type d'équipement tel qu'un décodeur de salon (set top box), ou lecteur de flux audio.

Ce dispositif DISP comporte une entrée pour recevoir un signal numérique qui dans le cas du codeur est un signal d'entrée x(n) et dans le cas du décodeur, le train binaire bst.

Le dispositif comporte également un processeur PROC de signaux numériques adapté pour réaliser des opérations de codage/décodage notamment sur un signal provenant de l'entrée E.

Ce processeur est relié à une ou plusieurs unités de mémoire MEM adaptées pour stocker des informations nécessaires au pilotage du dispositif pour le codage/décodage. Par exemple, ces unités de mémoire comportent des instructions pour la mise en oeuvre du procédé de décodage décrit ci-avant et notamment pour mettre en oeuvre les étapes de décodage selon un décodage par transformée inverse d'une trame précédente d'échantillons du signal numérique reçue et codée selon un codage par transformée, de décodage selon un décodage prédictif d'une trame courante d'échantillons du signal numérique reçue et codée selon un codage prédictif, une étape de réinitialisation d'au moins un état du décodage prédictif à une valeur par défaut prédéterminée et une étape d'addition-recouvrement qui combine un segment de signal synthétisé par décodage prédictif de la trame courante et un segment de signal synthétisé par décodage par transformée inverse, correspondant à un segment mémorisé du décodage de la trame précédente.

Lorsque le dispositif est de type codeur, ces unités de mémoire comportent des instructions pour la mise en oeuvre du procédé de codage décrit ci-avant et notamment pour mettre en oeuvre les étapes de codage d'une trame précédente d'échantillons du signal numérique selon un codage par transformée, de réception d'une trame courante d'échantillons du signal numérique à coder selon un codage prédictif, une étape de réinitialisation d'au moins un état du codage prédictif à une valeur par défaut prédéterminée.

Ces unités de mémoire peuvent également comporter des paramètres de calcul ou d'autres informations.

De manière plus générale, un moyen de stockage, lisible par un processeur, intégré ou non au codeur ou au décodeur, éventuellement amovible, mémorise un programme informatique mettant en oeuvre un procédé de décodage et/ou un procédé de codage selon l'invention. Les figures 3 et 6 peuvent par exemple illustrer l'algorithme d'un tel programme informatique.

Le processeur est également adapté pour stocker des résultats dans ces unités de mémoire. Enfin, le dispositif comporte une sortie S reliée au processeur pour fournir un signal de sortie qui dans le cas du codeur est un signal sous forme de train binaire bst et dans le cas du décodeur, un signal de sortie *x̂*(*n*).

## Revendications

1. Procédé de décodage d'un signal audio numérique, comportant les étapes de :
- décodage (E602) selon un décodage par transformée inverse d'une trame précédente d'échantillons du signal numérique reçue et codée selon un codage par transformée ;
- décodage (E608) selon un décodage prédictif d'une trame courante d'échantillons du signal numérique reçue et codée selon un codage prédictif,
le procédé étant **caractérisé en ce que** le décodage prédictif de la trame courante est un décodage prédictif de transition qui n'utilise pas de dictionnaire adaptatif issu de la trame précédente et **en ce qu'**il comporte en outre:
- une étape de réinitialisation (E606) d'au moins un état du décodage prédictif à une valeur par défaut prédéterminée;
- une étape d'addition-recouvrement (E609) qui combine un segment de signal synthétisé par décodage prédictif de la trame courante et un segment de signal synthétisé par décodage par transformée inverse, correspondant à un segment mémorisé du décodage de la trame précédente.

2. Procédé de décodage selon la revendication 1, **caractérisé en ce que** le décodage par transformée inverse a un retard de traitement inférieur à celui du décodage prédictif et **en ce que** le premier segment de trame courante décodée par décodage prédictif est remplacé par un segment issu du décodage de la trame précédente correspondant au décalage de retard et mis en mémoire lors du décodage de la trame précédente.

3. Procédé de décodage selon l'une des revendications précédentes, **caractérisé en ce que** le segment de signal synthétisé par décodage par transformée inverse est corrigé avant l'étape d'addition-recouvrement par l'application d'une fenêtre inverse compensant le fenêtrage préalablement appliqué au segment.

4. Procédé de décodage selon l'une des revendications précédentes, **caractérisé en ce que** le segment de signal synthétisé par décodage par transformée inverse est préalablement ré-échantillonné à la fréquence d'échantillonnage correspondante au segment de signal décodé de la trame courante.

5. Procédé de décodage selon la revendication 1, **caractérisé en ce qu'**un état du décodage prédictif est dans la liste des états suivants:
- la mémoire d'état d'un filtre de ré-échantillonnage à la fréquence interne du décodage prédictif;
- les mémoires d'état de filtres de pré-emphase/dé-emphase;
- les coefficients du filtre de prédiction linéaire;
- la mémoire d'état du filtre de synthèse ;
- la mémoire du dictionnaire adaptatif ;
- la mémoire d'état d'un post-filtre basse fréquence;
- la mémoire de quantification du gain de dictionnaire fixe.

6. Procédé de décodage selon la revendication 5, **caractérisé en ce que** le calcul des coefficients du filtre de prédiction linéaire de la trame courante s'effectue par le décodage des coefficients d'un filtre unique et en attribuant des coefficients identiques au filtre de prédiction linéaire de fin, de milieu et de début de trame.

7. Procédé de décodage selon la revendication 5, **caractérisé en ce que** le calcul des coefficients du filtre de prédiction linéaire de la trame courante comporte les étapes suivantes :
- détermination des valeurs décodées des coefficients du filtre de milieu de trame en utilisant les valeurs décodées des coefficients du filtre de fin de trame et une valeur prédéterminée de réinitialisation des coefficients du filtre de début de trame;
- remplacement des valeurs décodées des coefficients du filtre de début de trame par les valeurs décodées des coefficients du filtre de milieu de trame;
- détermination des coefficients du filtre de prédiction linéaire de la trame courante en utilisant les valeurs ainsi décodées des coefficients du filtre de fin, de milieu et de début de trame.

8. Procédé de décodage selon la revendication 5, **caractérisé en ce que** les coefficients du filtre de prédiction linéaire de début de trame sont réinitialisées à une valeur prédéterminée correspondant à une valeur moyenne des coefficients de filtre de prédiction à long terme et **en ce que** les coefficients de prédiction linéaire de la trame courante sont déterminés en utilisant les valeurs ainsi prédéterminées et les valeurs décodées des coefficients du filtre de fin de trame.

9. Procédé de codage d'un signal audio numérique, comportant les étapes de :
- codage (E302) d'une trame précédente d'échantillons du signal numérique selon un codage par transformée ;
- réception (E308) d'une trame courante d'échantillons du signal numérique à coder selon un codage prédictif,
le procédé étant **caractérisé en ce que** le codage prédictif de la trame courante est un codage prédictif de transition qui n'utilise pas de dictionnaire adaptatif issu de la trame précédente et **en ce qu'**il comporte en outre:
- une étape de réinitialisation (E306) d'au moins un état du codage prédictif à une valeur par défaut prédéterminée.

10. Procédé de codage selon la revendication 9, **caractérisé en ce que** les coefficients du filtre de prédiction linéaire font partie d'au moins un état du codage prédictif et **en ce que** le calcul des coefficients du filtre de prédiction linéaire de la trame courante s'effectue par la détermination des valeurs codées des coefficients d'un seul filtre de prédiction, soit de milieu soit de fin de trame et d'attribution de valeurs codées identiques pour les coefficients du filtre de prédiction de début de trame et de fin ou milieu de trame.

11. Procédé de codage selon la revendication 10, **caractérisé en ce qu'**au moins un état du codage prédictif est codé de manière directe.

12. Procédé de codage selon la revendication 9, **caractérisé en ce que** les coefficients du filtre de prédiction linéaire font partie d'au moins un état du codage prédictif et **en ce que** le calcul des coefficients du filtre de prédiction linéaire de la trame courante comporte les étapes suivantes :
- détermination des valeurs codées des coefficients du filtre de milieu de trame en utilisant les valeurs codées des coefficients du filtre de fin de trame et les valeurs prédéterminées de réinitialisation des coefficients du filtre de début de trame;
- remplacement des valeurs codées des coefficients du filtre de début de trame par les valeurs codées des coefficients du filtre de milieu de trame;
- détermination des coefficients du filtre de prédiction linéaire de la trame courante en utilisant les valeurs ainsi codées des coefficients du filtre de fin, de milieu et de début de trame.

13. Procédé de codage selon la revendication 9, **caractérisé en ce que** les coefficients du filtre de prédiction linéaire font partie d'au moins un état du codage prédictif, **en ce que** les coefficients du filtre de prédiction linéaire de début de trame sont réinitialisées à une valeur prédéterminée correspondant à une valeur moyenne des coefficients de filtre de prédiction à long terme et **en ce que** les coefficients de prédiction linéaire de la trame courante sont déterminés en utilisant les valeurs ainsi prédéterminées et les valeurs codées des coefficients du filtre de fin de trame.

14. Décodeur de signal audio numérique, comprenant :
- une entité de décodage (602) par transformée inverse apte à décoder une trame précédente d'échantillons du signal numérique reçue et codée selon un codage par transformée ;
- une entité de décodage (608) prédictif apte à décoder une trame courante d'échantillons du signal numérique reçue et codée selon un codage prédictif,
le décodeur étant caractérisé en ce le décodage prédictif de la trame courante est un décodage prédictif de transition qui n'utilise pas de dictionnaire adaptatif issu de la trame précédente et en ce qu'il comporte en outre:
- un module de réinitialisation (606) apte à réinitialiser au moins un état du décodage prédictif par une valeur par défaut prédéterminée;
- un module de traitement (609) apte à effectuer une addition-recouvrement qui combine un segment de signal synthétisé par décodage prédictif de la trame courante et un segment de signal synthétisé par décodage par transformée inverse, correspondant à un segment mémorisé du décodage de la trame précédente.

15. Codeur de signal audio numérique, comprenant :
- une entité de codage par transformée (302) apte à coder une trame précédente d'échantillons du signal numérique ;
- une entité de codage prédictif (308) apte à coder une trame courante d'échantillons du signal numérique,
le codeur étant **caractérisé en ce que** le codage prédictif de la trame courante est un codage prédictif de transition qui n'utilise pas de dictionnaire adaptatif issu de la trame précédente et **en ce qu'**il comporte en outre:
- un module de réinitialisation (306) apte à réinitialiser au moins un état du codage prédictif par une valeur par défaut prédéterminée.

16. Moyen de stockage lisible par un processeur, mémorisant un programme informatique comportant des instructions pour l'exécution des étapes du procédé de décodage selon l'une des revendications 1 à 8 et/ou du procédé de codage selon l'une des revendications 9 à 13.

## Patentansprüche

1. Verfahren zur Decodierung eines digitalen Audiosignals, welches die folgenden Schritte aufweist:
- Decodierung (E602) eines vorhergehenden Rahmens von Abtastwerten des empfangenen und gemäß einer Transformationscodierung codierten digitalen Signals gemäß einer Decodierung durch inverse Transformation;
- Decodierung (E608) eines aktuellen Rahmens von Abtastwerten des empfangenen und gemäß einer prädiktiven Codierung codierten digitalen Signals gemäß einer prädiktiven Decodierung,
wobei das Verfahren **dadurch gekennzeichnet ist, dass** die prädiktive Decodierung des aktuellen Rahmens eine prädiktive Übergangsdecodierung ist, welche kein aus dem vorhergehenden Rahmen hervorgegangenes adaptives Wörterbuch verwendet, und dadurch, dass es außerdem aufweist:
- einen Schritt der Neuinitialisierung (E606) wenigstens eines Zustands der prädiktiven Decodierung mit einem vorbestimmten Standardwert;
- einen Schritt der Addition-Überlagerung (E609), welcher ein durch prädiktive Decodierung des aktuellen Rahmens synthetisiertes Signalsegment und ein durch Decodierung durch inverse Transformation synthetisiertes Signalsegment, das einem gespeicherten Segment der Decodierung des vorhergehenden Rahmens entspricht, kombiniert.

2. Verfahren zur Decodierung nach Anspruch 1, **dadurch gekennzeichnet, dass** die Decodierung durch inverse Transformation eine Verarbeitungsverzögerung aufweist, die kleiner als diejenige der prädiktiven Decodierung ist, und dadurch, dass das erste Segment des durch prädiktive Decodierung decodierten aktuellen Rahmens durch ein aus der Decodierung des vorhergehenden Rahmens hervorgegangenes Segment ersetzt wird, das der Verzögerungsverschiebung entspricht und bei der Decodierung des vorhergehenden Rahmens im Speicher abgelegt wurde.

3. Verfahren zur Decodierung nach einem der vorhergehenden Ansprüche, **dadurch gekennzeichnet, dass** das durch Decodierung durch inverse Transformation synthetisierte Signalsegment vor dem Schritt der Addition-Überlagerung durch Anwendung inversen Fensters, das die zuvor auf das Segment angewendete Fensterung kompensiert, korrigiert wird.

4. Verfahren zur Decodierung nach einem der vorhergehenden Ansprüche, **dadurch gekennzeichnet, dass** das durch Decodierung durch inverse Transformation synthetisierte Signalsegment zuvor mit der Abtastfrequenz, die dem decodierten Signalsegment des aktuellen Rahmens entspricht, erneut abgetastet wird.

5. Verfahren zur Decodierung nach Anspruch 1, **dadurch gekennzeichnet, dass** ein Zustand der prädiktiven Decodierung in der Liste der folgenden Zustände enthalten ist:
- der Zustandsspeicher eines Filters der Neuabtastung mit der internen Frequenz der prädiktiven Decodierung;
- die Zustandsspeicher von Prä-Emphasis-/De-Emphasis-Filtern;
- die Koeffizienten des Linearprädiktionsfilters;
- der Zustandsspeicher des Synthesefilters;
- der Speicher des adaptiven Wörterbuchs;
- der Zustandsspeicher eines Niederfrequenz-Nachfilters;
- der Speicher der Quantifizierung des Verstärkungsfaktors des festen Wörterbuchs.

6. Verfahren zur Decodierung nach Anspruch 5, **dadurch gekennzeichnet, dass** die Berechnung der Koeffizienten des Linearprädiktionsfilters des aktuellen Rahmens durch die Decodierung der Koeffizienten eines einzigen Filters durchgeführt wird, und indem dem Linearprädiktionsfilter des Rahmenendes, der Rahmenmitte und des Rahmenanfangs identische Koeffizienten zugewiesen werden.

7. Verfahren zur Decodierung nach Anspruch 5, **dadurch gekennzeichnet, dass** die Berechnung der Koeffizienten des Linearprädiktionsfilters des aktuellen Rahmens die folgenden Schritte beinhaltet:
- Bestimmung der decodierten Werte der Koeffizienten des Rahmenmitte-Filters unter Verwendung der decodierten Werte der Koeffizienten des Rahmenende-Filters und eines vorbestimmten Wertes der Neuinitialisierung der Koeffizienten des Rahmenanfang-Filters;
- Ersetzen der decodierten Werte der Koeffizienten des Rahmenanfang-Filters durch die decodierten Werte der Koeffizienten des Rahmenmitte-Filters;
- Bestimmung der Koeffizienten des Linearprädiktionsfilters des aktuellen Rahmens unter Verwendung der so decodierten Werte der Koeffizienten des Rahmenende-, Rahmenmitte- und Rahmenanfang-Filters.

8. Verfahren zur Decodierung nach Anspruch 5, **dadurch gekennzeichnet, dass** die Koeffizienten des Linearprädiktionsfilters des Rahmenanfangs mit einem vorbestimmten Wert neu initialisiert werden, der einem Mittelwert der Koeffizienten eines Langzeitprädiktionsfilters entspricht, und dadurch, dass die Linearprädiktionskoeffizienten des aktuellen Rahmens unter Verwendung der so vorbestimmten Werte und der decodierten Werte der Koeffizienten des Rahmenende-Filters bestimmt werden.

9. Verfahren zur Codierung eines digitalen Audiosignals, welches die folgenden Schritte aufweist:
- Codierung (E302) eines vorhergehenden Rahmens von Abtastwerten des digitalen Signals gemäß einer Transformationscodierung;
- Empfang (E308) eines aktuellen Rahmens von Abtastwerten des gemäß einer prädiktiven Codierung zu codierenden digitalen Signals,
wobei das Verfahren **dadurch gekennzeichnet ist, dass** die prädiktive Codierung des aktuellen Rahmens eine prädiktive Übergangscodierung ist, welche kein aus dem vorhergehenden Rahmen hervorgegangenes adaptives Wörterbuch verwendet, und dadurch, dass es außerdem aufweist:
- einen Schritt der Neuinitialisierung (E306) wenigstens eines Zustands der prädiktiven Codierung mit einem vorbestimmten Standardwert.

10. Verfahren zur Codierung nach Anspruch 9, **dadurch gekennzeichnet, dass** die Koeffizienten des Linearprädiktionsfilters Teil wenigstens eines Zustands der prädiktiven Codierung sind, und dadurch, dass die Berechnung der Koeffizienten des Linearprädiktionsfilters des aktuellen Rahmens durch die Bestimmung der codierten Werte der Koeffizienten eines einzigen Prädiktionsfilters entweder der Rahmenmitte oder des Rahmenendes und die Zuweisung identischer codierter Werte für die Koeffizienten des Prädiktionsfilters des Rahmenanfangs und des Rahmenendes oder der Rahmenmitte durchgeführt wird.

11. Verfahren zur Codierung nach Anspruch 10, **dadurch gekennzeichnet, dass** wenigstens ein Zustand der prädiktiven Codierung direkt codiert wird.

12. Verfahren zur Codierung nach Anspruch 9, **dadurch gekennzeichnet, dass** die Koeffizienten des Linearprädiktionsfilters Teil wenigstens eines Zustands der prädiktiven Codierung sind, und dadurch, dass die Berechnung der Koeffizienten des Linearprädiktionsfilters des aktuellen Rahmens die folgenden Schritte beinhaltet:
- Bestimmung der codierten Werte der Koeffizienten des Rahmenmitte-Filters unter Verwendung der codierten Werte der Koeffizienten des Rahmenende-Filters und der vorbestimmten Werte der Neuinitialisierung der Koeffizienten des Rahmenanfang-Filters;
- Ersetzen der codierten Werte der Koeffizienten des Rahmenanfang-Filters durch die codierten Werte der Koeffizienten des Rahmenmitte-Filters;
- Bestimmung der Koeffizienten des Linearprädiktionsfilters des aktuellen Rahmens unter Verwendung der so codierten Werte der Koeffizienten des Rahmenende-, Rahmenmitte- und Rahmenanfang-Filters.

13. Verfahren zur Codierung nach Anspruch 9, **dadurch gekennzeichnet, dass** die Koeffizienten des Linearprädiktionsfilters Teil wenigstens eines Zustands der prädiktiven Codierung sind, und dadurch, dass die Koeffizienten des Linearprädiktionsfilters des Rahmenanfangs mit einem vorbestimmten Wert neu initialisiert werden, der einem Mittelwert der Koeffizienten eines Langzeitprädiktionsfilters entspricht, und dadurch, dass die Linearprädiktionskoeffizienten des aktuellen Rahmens unter Verwendung der so vorbestimmten Werte und der codierten Werte der Koeffizienten des Rahmenende-Filters bestimmt werden.

14. Decodierer für ein digitales Audiosignal, welcher umfasst:
- eine Entität zur Decodierung (602) durch inverse Transformation, die geeignet ist, einen vorhergehenden Rahmen von Abtastwerten des empfangenen und gemäß einer Transformationscodierung codierten digitalen Signals zu decodieren;
- eine Entität zur prädiktiven Decodierung (608), die geeignet ist, einen aktuellen Rahmen von Abtastwerten des empfangenen und gemäß einer prädiktiven Codierung codierten digitalen Signals zu decodieren,
wobei der Decodierer **dadurch gekennzeichnet ist, dass** die prädiktive Decodierung des aktuellen Rahmens eine prädiktive Übergangsdecodierung ist, welche kein aus dem vorhergehenden Rahmen hervorgegangenes adaptives Wörterbuch verwendet, und dadurch, dass er außerdem aufweist:
- ein Neuinitialisierungsmodul (606), das geeignet ist, wenigstens einen Zustand der prädiktiven Decodierung mit einem vorbestimmten Standardwert neu zu initialisieren;
- ein Verarbeitungsmodul (609), das geeignet ist, eine Addition-Überlagerung durchzuführen, welche ein durch prädiktive Decodierung des aktuellen Rahmens synthetisiertes Signalsegment und ein durch Decodierung durch inverse Transformation synthetisiertes Signalsegment, das einem gespeicherten Segment der Decodierung des vorhergehenden Rahmens entspricht, kombiniert.

15. Codierer für ein digitales Audiosignal, welcher umfasst:
- eine Entität zur Transformationscodierung (302), die geeignet ist, einen vorhergehenden Rahmen von Abtastwerten des digitalen Signals zu codieren;
- eine Entität zur prädiktiven Codierung (308), die geeignet ist, einen aktuellen Rahmen von Abtastwerten des digitalen Signals zu codieren, wobei der Codierer **dadurch gekennzeichnet ist, dass** die prädiktive Decodierung des aktuellen Rahmens eine prädiktive Übergangsdecodierung ist, welche kein aus dem vorhergehenden Rahmen hervorgegangenes adaptives Wörterbuch verwendet, und dadurch, dass er außerdem aufweist:
- ein Neuinitialisierungsmodul (306), das geeignet ist, wenigstens einen Zustand der prädiktiven Codierung mit einem vorbestimmten Standardwert neu zu initialisieren.

16. Von einem Prozessor lesbares Speichermedium, welches ein Computerprogramm speichert, das Anweisungen zur Ausführung der Schritte des Verfahrens zur Decodierung nach einem der Ansprüche 1 bis 8 und/oder des Verfahrens zur Codierung nach einem der Ansprüche 9 bis 13 umfasst.

## Claims

1. Method for decoding a digital audio signal, comprising the steps of:
- decoding (E602) according to an inverse transform decoding of a previous frame of samples of the digital signal, received and coded according to a transform coding;
- decoding (E608) according to a predictive decoding of a current frame of samples of the digital signal, received and coded according to a predictive coding,
the method being **characterized in that** the predictive decoding of the current frame is a transition predictive decoding which does not use any adaptive dictionary arising from the previous frame and **in that** it furthermore comprises:
- a step of reinitialization (E606) of at least one state of the predictive decoding to a predetermined default value;
- an overlap-add step (E609) which combines a signal segment synthesized by predictive decoding of the current frame and a signal segment synthesized by inverse transform decoding, corresponding to a stored segment of the decoding of the previous frame.

2. Decoding method according to Claim 1, **characterized in that** the inverse transform decoding has a smaller processing delay than that of the predictive decoding and **in that** the first segment of current frame decoded by predictive decoding is replaced with a segment arising from the decoding of the previous frame corresponding to the delay shift and placement in memory during the decoding of the previous frame.

3. Decoding method according to either of the preceding claims, **characterized in that** the signal segment synthesized by inverse transform decoding is corrected before the overlap-add step by the application of an inverse window compensating the windowing previously applied to the segment.

4. Decoding method according to one of the preceding claims, **characterized in that** the signal segment synthesized by inverse transform decoding is resampled beforehand at the sampling frequency corresponding to the decoded signal segment of the current frame.

5. Decoding method according to Claim 1, **characterized in that** a state of the predictive decoding is in the list of the following states:
- the state memory for a filter for resampling at the internal frequency of the predictive decoding;
- the state memories for pre-emphasis/de-emphasis filters;
- the coefficients of the linear prediction filter;
- the state memory of the synthesis filter;
- the memory of the adaptive dictionary;
- the state memory of a low-frequency post-filter;
- the quantization memory for the fixed dictionary gain.

6. Decoding method according to Claim 5, **characterized in that** the calculation of the coefficients of the linear prediction filter for the current frame is performed by the decoding of the coefficients of a unique filter and by allotting identical coefficients to the end-, middle- and start-of-frame linear prediction filter.

7. Decoding method according to Claim 5, **characterized in that** the calculation of the coefficients of the linear prediction filter for the current frame comprises the following steps:
- determination of the decoded values of the coefficients of the middle-of-frame filter by using the decoded values of the coefficients of the end-of-frame filter and a predetermined reinitialization value of the coefficients of the start-of-frame filter;
- replacement of the decoded values of the coefficients of the start-of-frame filter by the decoded values of the coefficients of the middle-of-frame filter;
- determination of the coefficients of the linear prediction filter for the current frame by using the values thus decoded of the coefficients of the end-, middle- and start-of-frame filter.

8. Decoding method according to Claim 5, **characterized in that** the coefficients of the start-of-frame linear prediction filter are reinitialized to a predetermined value corresponding to an average value of the long-term prediction filter coefficients and **in that** the linear prediction coefficients for the current frame are determined by using the values thus predetermined and the decoded values of the coefficients of the end-of-frame filter.

9. Method for coding a digital audio signal, comprising the steps of:
- coding (E302) of a previous frame of samples of the digital signal according to a transform coding;
- reception (E308) of a current frame of samples of the digital signal to be coded according to a predictive coding,
the method being **characterized in that** the predictive coding of the current frame is a transition predictive coding which does not use any adaptive dictionary arising from the previous frame and **in that** it furthermore comprises:
- a step (E306) of reinitialization of at least one state of the predictive coding to a predetermined default value.

10. Coding method according to Claim 9, **characterized in that** the coefficients of the linear prediction filter form part of at least one state of the predictive coding and **in that** the calculation of the coefficients of the linear prediction filter for the current frame is performed by the determination of the coded values of the coefficients of a single prediction filter, either of middle or of end of frame and of allotting of identical coded values for the coefficients of the start-of-frame and end-or middle-of-frame prediction filter.

11. Coding method according to Claim 10, **characterized in that** at least one state of the predictive coding is coded in a direct manner.

12. Coding method according to Claim 9, **characterized in that** the coefficients of the linear prediction filter form part of at least one state of the predictive coding and **in that** the calculation of the coefficients of the linear prediction filter for the current frame comprises the following steps:
- determination of the coded values of the coefficients of the middle-of-frame filter by using the coded values of the coefficients of the end-of-frame filter and the predetermined reinitialization values of the coefficients of the start-of-frame filter;
- replacement of the coded values of the coefficients of the start-of-frame filter by the coded values of the coefficients of the middle-of-frame filter;
- determination of the coefficients of the linear prediction filter for the current frame by using the values thus coded of the coefficients of the end-, middle- and start-of-frame filter.

13. Coding method according to Claim 9, **characterized in that** the coefficients of the linear prediction filter form part of at least one state of the predictive coding, **in that** the coefficients of the start-of-frame linear prediction filter are reinitialized to a predetermined value corresponding to an average value of the long-term prediction filter coefficients and **in that** the linear prediction coefficients for the current frame are determined by using the values thus predetermined and the coded values of the coefficients of the end-of-frame filter.

14. Digital audio signal decoder, comprising:
- an inverse transform decoding entity (602) able to decode a previous frame of samples of the digital signal, received and coded according to a transform coding;
- a predictive decoding entity (608) able to decode a current frame of samples of the digital signal, received and coded according to a predictive coding,
the decoder being **characterized in that** the predictive decoding of the current frame is a transition predictive decoding which does not use any adaptive dictionary arising from the previous frame and **in that** it furthermore comprises:
- a reinitialization module (606) able to reinitialize at least one state of the predictive decoding by a predetermined default value;
- a processing module (609) able to perform an overlap-add which combines a signal segment synthesized by predictive decoding of the current frame and a signal segment synthesized by inverse transform decoding, corresponding to a stored segment of the decoding of the previous frame.

15. Digital audio signal coder, comprising:
- a transform coding entity (302) able to code a previous frame of samples of the digital signal;
- a predictive coding entity (308) able to code a current frame of samples of the digital signal,
the coder being **characterized in that** the predictive coding of the current frame is a transition predictive coding which does not use any adaptive dictionary arising from the previous frame and **in that** it furthermore comprises:
- a reinitialization module (306) able to reinitialize at least one state of the predictive coding by a predetermined default value.

16. Storage means readable by a processor, storing a computer program comprising instructions for the execution of the steps of the decoding method according to one of Claims 1 to 8 and/or of the coding method according to one of Claims 9 to 13.
